# DEMANDE DE BREVET EUROPEEN

(11) **EP 0 583 175 A1**
(43) Date de publication de la demande: **16.02.1994**
(21) Numéro de dépôt: 93401589.2
(22) Date de dépôt: 22.06.1993
(51) Int. Cl.: H04B 7/00, H04B 1/40

(54) **Etage d'excitation d'un tube d'émission pour émetteur à ondes courtes**

(30) Priorité: 26.06.1992 FR 9207884
(71) Demandeur: THOMSON-CSF, 75008 Paris (FR)
(72) Inventeur: Darges, Bernard, F-92402 Courbevoie Cedex (FR)
(74) Mandataire: Lincot, Georges

(57) **Abrégé**

L'étage d'excitation comprend un nombre déterminé de modules d'amplifications à semiconducteurs (6₁-6N) montés en parallèle à l'entrée d'un dispositif de couplage (8) pour coupler les sorties des modules d'amplification (6₁ à 6N) à l'entrée du tube d'émission (2) ainsi qu'un dispositif d'écrêtage à diodes disposé à l'intérieur du dispositif de couplage (8) pour écrêter les impulsions de court-circuit des électrodes du tube d'émission (2) qui apparaissent à la sortie du dispositif de couplage (8).

Application : Emetteurs ondes courtes à bande latérale unique.

## Description

La présente invention concerne un étage d'excitation d'un tube d'émission pour émetteur à ondes courtes. Elle s'applique notamment à la réalisation d'émetteurs de radiodiffusion à bande latérale unique.

Selon l'art antérieur, les émetteurs de radiodiffusion ondes courtes de forte puissance sont équipés au minimum de deux tubes radiofréquences, un tube final de très forte puissance pour les puissances supérieures par exemple à 100 Kw et un tube d'excitation du tube final, d'une puissance de quelques Kw. L'intérêt de cette disposition est que le tube d'excitation permet à l'émetteur de résister assez bien aux impulsions de quelques Kvolts qui apparaissent lors des courts-circuits développés pendant des intervalles de temps brefs de l'ordre de 500 nanosecondes entre les électrodes, anode-grille ou écran grille du tube d'émission. Cependant, lorsqu'à cause de ce phénomène une panne du tube d'excitation intervient, cette disposition rend, du fait de l'encombrement important de ce type d'installation, quasiment impossible des interventions rapides des équipes de maintenance chargées de remplacer l'étage d'excitation défaillant et pose un problème d'exploitation à la station d'émission du fait que le fonctionnement de l'émetteur se trouve interrompu pendant de nombreuses heures, ce qui est économiquement difficilement supportable compte tenu des coûts horaires élevés d'exploitation des émetteurs de radiodiffusion.

Le but de l'invention est de pallier les inconvénients précités.

A cet effet, l'invention a pour objet un étage d'excitation d'un tube d'émission pour émetteur à ondes courtes caractérisé en ce qu'il comprend un nombre déterminé de modules d'amplifications à semiconducteurs montés en parallèle à l'entrée d'un dispositif de couplage pour coupler les sorties des modules d'amplification à l'entrée du tube d'émission ainsi qu'un dispositif d'écrêtage à diodes disposé à l'intérieur des dispositifs de couplage pour écrêter les impulsions de court-circuit des électrodes du tube d'émission qui apparaissent à la sortie du dispositif de couplage.

L'invention a pour principal avantage qu'elle permet grâce à la conception modulaire de l'étage d'excitation d'assurer un fonctionnement de l'émetteur même en cas de défaillance de l'un de ses modules d'amplification et de permettre grâce à l'extrême miniaturisation des modules des interventions rapides des équipes de maintenance qui peuvent ainsi assurer sans aucun effort l'interchangeabilité des modules défaillants.

D'autres caractéristiques et avantages de l'invention apparaîtront à l'aide de la description qui suit faite en regard des dessins annexés qui représentent :
- la figure 1 une chaîne d'émission qui comprend un étage d'excitation selon l'invention ;
- la figure 2 une représentation fonctionnelle détaillée de la chaîne d'émission de la figure 1 ;
- la figure 3 un mode de réalisation de l'étage d'attaque des modules d'amplification de la figure 2 ;
- la figure 4 un mode de réalisation d'un module d'amplification selon l'invention ;
- la figure 5 un mode de réalisation d'un coupleur selon l'invention ;
- la figure 6 un mode de réalisation d'un circuit de charge de l'étage d'excitation de la figure 2 ;
- la figure 7 un mode de réalisation de l'écrêteur à diode de la figure 5.

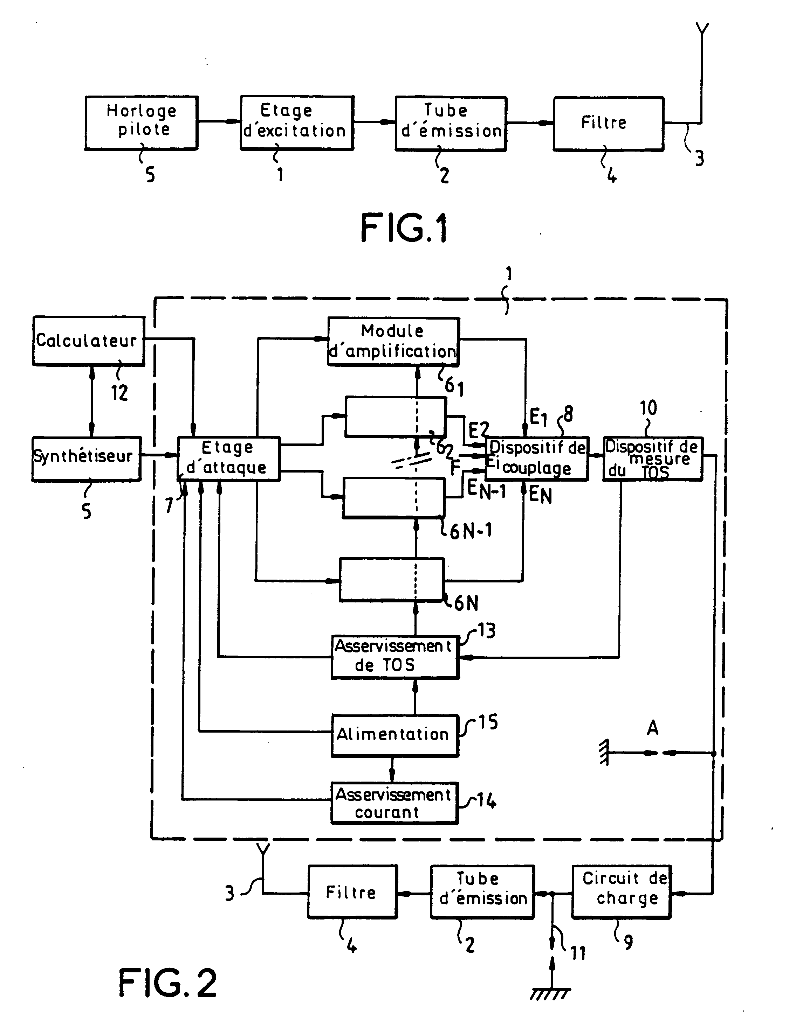

La chaîne d'émission qui est représentée à la figure 1 est celle qui équipe classiquement la voie de phase des émetteurs à bande latérale unique (BLU) ou l'information HF non modulée en phase dans le cas d'une émission AM. Elle comporte un étage d'excitation 1 d'un tube d'émission 2 alimentant une antenne 3 au travers d'un filtre 4. A cette fin l'étage d'excitation 1 reçoit l'information de phase d'une horloge 5 formée par un synthétiseur de fréquence ou tout dispositif équivalent. Naturellement d'autres types de modulation de la chaîne d'émission sont aussi réalisables en modifiant seulement l'attaque de l'étage d'excitation.

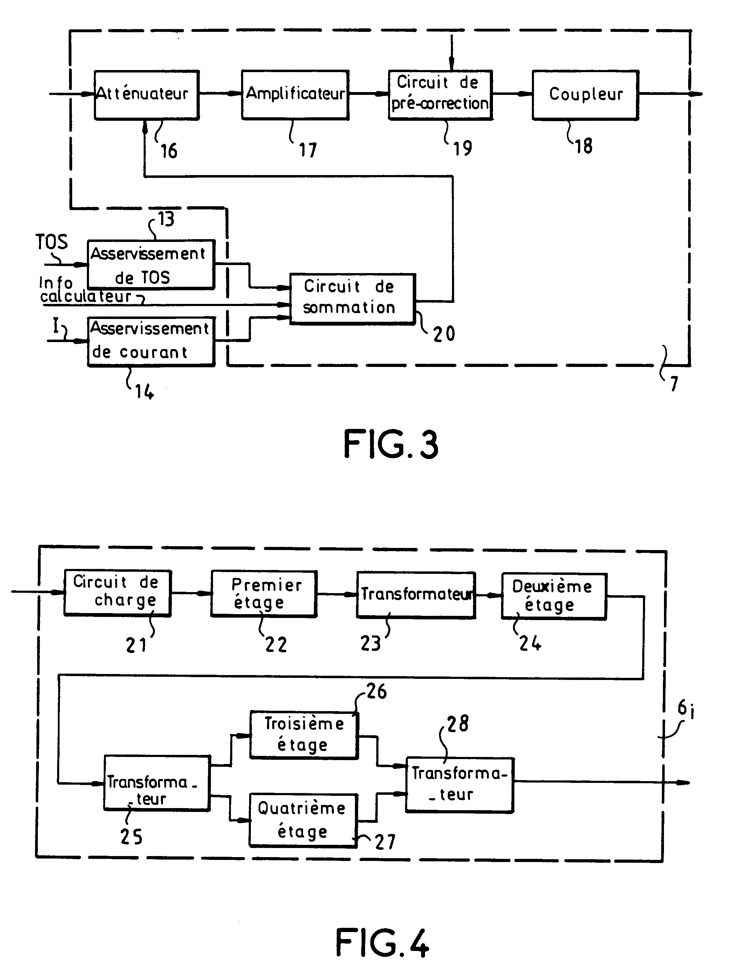

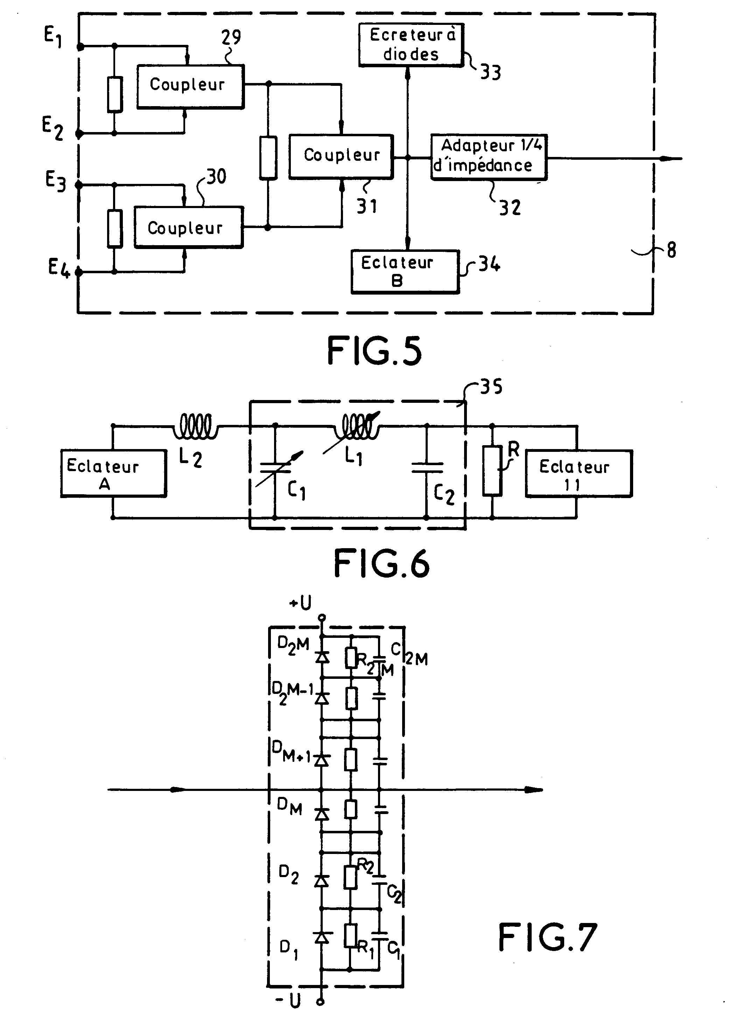

Suivant le mode de réalisation de la figure 2 où les éléments homologues à ceux de la figure 1 sont repérés avec les mêmes références, l'étage d'excitation 1 qui est représenté à l'intérieur d'une ligne fermée en pointillés, comporte un nombre déterminé N de modules d'amplification référencés de 6₁ à 6_{N} montés en parallèle entre un étage d'attaque 7 et un dispositif de couplage 8. Le nombre N est déterminé en fonction de la puissance qui est à fournir au tube d'émission 2. Typiquement pour un émetteur à ondes courtes 250 Kw utilisant par exemple comme tube d'émission 2, un tube de 500 Kw du type TH558 commercialisé par la Demanderesse, un nombre N égal à 4 de modules 6ᵢ apparaît suffisant pour obtenir une puissance d'excitation du tube d'émission de l'ordre de 3 Kw, pour un émetteur 500 Kw 8 modules sont nécessaires. Les sorties des modules d'amplification 6₁ à 6_{N} sont reliées à un dispositif de couplage 8. Le dispositif de couplage 8 est chargé par un circuit de charge 9 au travers d'un dispositif de mesure 10 du taux d'onde stationnaire ou TOS présent à la sortie du dispositif de couplage 8. Le circuit de charge 9 applique de façon connue le signal amplifié sortant de l'étage d'excitation 1 à l'entrée du tube d'émission 2. Une protection sous la forme d'un éclateur à boule 11 est disposée à la sortie du circuit de charge 9 pour écrêter les impulsions à très haut voltage, de l'ordre de 10 kilovolts, qui proviennent du tube d'émission 2 et qui sont provoquées par des courts-circuits inter électrodes du tube deux autres éclateurs à gaz sont disposés en A et B pour écrêter ces mêmes impulsions (figures 5 et 6). Un calculateur 12 est également prévu pour appliquer des valeurs de correction au signal fourni par le synthétiseur 5 à l'entrée de l'étage d'attaque 7 et agir sur l'angle d'ouverture du tube d'émission 2. L'étage d'excitation 1 comporte également un circuit d'asservissement de TOS 13 et un circuit d'asservissement en courant 14 pour appliquer des valeurs de correction de TOS et de courant d'alimentation à l'étage d'attaque 7 et agir sur l'amplitude des signaux fournis par le synthétiseur de fréquence 5. Sur la figure 2, l'alimentation des circuits de l'étage d'excitation 1 est assurée par l'alimentation figurée en 15. L'étage d'attaque 7 qui est représenté sur le schéma de la figure 3 comporte un atténuateur à diodes PIN 16 couplé à un amplificateur 17, ce dernier étant couplé à un coupleur 18 par l'intermédiaire d'un circuit de précorrection 19. L'étage d'attaque de la figure 3 comporte également un circuit de sommation 20 des valeurs de TOS et de courant fournies par le circuit d'asservissement de TOS 13 et de courant 14. Ces valeurs sont elles-mêmes ajoutées à des informations de correction provenant du calculateur 12 pour les appliquer à des entrées de commande d'atténuation de l'atténuateur à diodes PIN 16. Un module d'amplification 6ᵢ comporte de la façon représentée à la figure 4 un circuit de charge 21, un premier étage d'amplification 22, un transformateur 23, un deuxième étage d'amplification 24 et un transformateur 25. Les éléments 21 à 25 sont reliés en série aux entrées respectives d'un troisième étage 26 et d'un quatrième étage 27 montés en puch-pull. Les sorties des troisième et quatrième étages 26 et 27 sont reliées à l'entrée d'un transformateur de puissance 28. La sortie du transformateur 28 est reliée à une entrée du dispositif de couplage 8 formée par plusieurs coupleurs à 3dB reliés en cascade, dont un mode de réalisation à quatre entrées de couplage E₁ à E₄ est représenté à la figure 5. Le dispositif représenté à la figure 5 comporte un premier 29 et un deuxième 30 coupleur à deux entrées respectivement référencées E₁, E₂ et E₃, E₄ et dont les sorties sont reliées à un troisième coupleur à deux entrées 31. Les coupleurs 29, 30 et 31 sont typiquement des coupleurs à 3 dB réalisés au moyen de lignes coaxiales. Dans ces coupleurs l'impédance caractéristique de chacune des entrées E₁ à E₄ est de l'ordre de 50 ohms et elle est divisée par 2 sur chacune des sorties des coupleurs 29 et 30. De la sorte les entrées du coupleur 31 voient une impédance caractéristique de 25 ohms et cette impédance est transformée à la sortie du coupleur 31 en une impédance de 12,5 ohms. Comme cette impédance n'est pas suffisante pour attaquer le circuit grille celle-ci est multipliée par quatre à l'aide d'un transformateur à lignes 32 d'impédance caractéristique 25 ohms. Pour protéger le circuit ainsi réalisé contre des surtensions provenant du tube d'émission un étage écrêteur à diodes 33 et un éclateur à gaz 34 sont interposés entre la sortie du coupleur 31 et l'entrée de l'adaptateur d'impédance 32 ; un autre éclateur à gaz est mis en sortie de cet adaptateur 32. La sortie de l'adaptateur d'impédance 32 est reliée au circuit de charge 9 de la figure 2 constitué comme le montre la figure 6 d'une cellule en (π) 35 passe-bande formée d'une inductance L₁ et de deux capacités C₁ et C₂ montées dans les deux branches du (π) ainsi qu'une inductance L₂ reliée en série entre l'entrée de la cellule en (π) 35 et la sortie de l'adaptateur d'impédance 32. La sortie de la cellule en (π) 35 est chargée par une résistance R.

Un mode de réalisation de l'écrêteur à diode 33 est représenté à la figure 7. Celui-ci comporte de façon connue un nombre déterminé de diodes D₁ à D_{2M} reliées en série dans le sens non passant entre une tension positive U et une tension négative -U. Le point de liaison commun entre les diodes Dₘ et D_{M+1} est relié à la sortie du coupleur 31. Les résistances R₁ à R_{2M} et des capacités C₁ à C_{2M} sont reliées respectivement en parallèle aux bornes des diodes D₁ à D_{2M}.

Ainsi réalisé l'écrêteur à diode 33 permet d'absorber avec les éclateurs 11, A, B, les impulsions à très haute tension provenant du tube d'émission 2 et de protéger ainsi l'étage d'excitation 1 contre toute dégradation d'un de ses modules d'amplification 6₁ à 6_{N}. Egalement, les circuits d'asservissement du TOS 13, et du courant 14 permettent en agissant sur l'atténuateur à diodes PIN 16 d'assurer une protection de l'étage d'excitation 1 contre les désadaptations du tube d'émission 2 avec l'étage d'excitation et contre les surexcitations du circuit d'attaque 7.

Naturellement, l'invention n'est pas limitée aux exemples de réalisation des circuits de l'émetteur qui viennent d'être décrits, et il va de soi que d'autres modes de réalisations notamment en ce qui concerne la structure des modules d'amplification restent envisageables sans pourtant s'écarter du cadre même de l'invention.

## Revendications

1. Etage d'excitation (1) d'un tube d'émission (2) pour émetteur à ondes courtes caractérisé en ce qu'il comprend un nombre déterminé de modules d'amplifications à semiconducteurs (6₁-6_{N}) montés en parallèle à l'entrée d'un dispositif de couplage (8) pour coupler les sorties des modules d'amplification (6₁ à 6_{N}) à l'entrée du tube d'émission (2) ainsi qu'un dispositif d'écrêtage à diodes (33) disposé à l'intérieur du dispositif de couplage pour écrêter les impulsions de court-circuit des électrodes du tube d'émission (2) qui apparaissent à la sortie du dispositif de couplage (8).

2. Etage d'excitation selon la revendication 1 caractérisé en ce qu'il comprend un étage d'attaque (7) comprenant un atténuateur à diodes PIN (16) commandé par un circuit d'asservissement du taux d'onde stationnaire (13) existant entre la sortie de l'étage d'excitation (1) et le tube d'émission (2).

3. Etage d'excitation selon la revendication 2 caractérisé en ce qu'il comprend un circuit d'asservissement en courant (14) pour commander l'atténuateur à diodes PIN (16) et diminuer le gain de l'étage d'excitation lorsqu'il y a surexcitation du circuit d'attaque 7 ou disfonctionnement de l'un des modules en courant entre le tube d'émission (2) et l'étage d'excitation (1).

4. Etage d'excitation selon les revendications 2 et 3 caractérisé en ce qu'il comprend un circuit de sommation (20) pour additionner les valeurs du taux d'onde stationnaire existant entre le tube d'émission (2) et l'étage d'excitation (1), à la valeur du courant d'alimentation de l'étage d'excitation et à une valeur de correction de l'angle d'ouverture du tube de puissance (2) fourni par un calculateur (12), et appliquer le résultat de l'addition sur les entrées de commande de l'atténuateur à diodes PIN (16).

5. Etage d'excitation selon l'une quelconque des revendications 1 à 4 caractérisé en ce que le circuit de couplage comprend un éclateur à boule (11) placé sur sa sortie, un éclateur à gaz (A) placé à la sortie du coupleur (31), et un éclateur à gaz placé à la sortie de l'adaptateur d'impédance (32).

6. Etage d'excitation selon l'une quelconque des revendications 2 à 5 caractérisé en ce que le circuit d'asservissement du taux d'onde stationnaire (13) est commandé à partir d'un dispositif de mesure de taux d'onde stationnaire (10) couplé à la sortie du dispositif de couplage (8).

7. Etage d'excitation selon l'une quelconque des revendications 1 à 6 caractérisé en ce que chaque module de puissance (6₁ à 6_{N}) comporte un étage de puissance (26, 27) de type "push-pull" à transistors.

8. Etage d'excitation selon l'une quelconque des revendications 1 à 7 caractérisé en ce que le dispositif de couplage comporte un ensemble de coupleurs à 3dB reliés en cascade.

9. Etage d'excitation selon l'une quelconque des revendications 1 à 8 caractérisé en ce qu'il comprend un circuit de charge (9) formé par une cellule en (π) passe bande fourni par une première inductance (L₁) et une capacité (C₁, C₂) dans chacune des deux branches du (π) et d'une deuxième inductance (L₂) interposée entre la sortie de l'étage d'excitation (1) et l'entrée de la cellule en (π).

10. Etage d'excitation selon l'une quelconque des revendications 1 à 9 caractérisé en ce qu'il comporte 2M diodes reliées en série dans le sens non passant entre deux tensions de polarisation +U et -U, dans lesquelles le point commun aux diodes M et M+1 est couplé à la sortie du dispositif de couplage (31).
